Europäisches Patentamt

European Patent Office

Office européen des brevets

(11) Publication number: **0 258 794**
**A2**

# EUROPEAN PATENT APPLICATION

(21) Application number: **87112345.1**

(22) Date of filing: **25.08.87**

(51) Int. Cl.⁴: **H01L 21/00**

(30) Priority: **05.09.86 US 903620**

(43) Date of publication of application:
**09.03.88 Bulletin 88/10**

(84) Designated Contracting States:
**DE FR GB IT NL**

(71) Applicant: **THE PERKIN-ELMER CORPORATION**
**761 Main Avenue**
**Norwalk Connecticut 06859-0074(US)**

(72) Inventor: **Bantz, George H.**
**148 Fieldcrest Road**
**New Canaan Connecticut 06840(US)**

(74) Representative: **Patentanwälte Grünecker,**
**Kinkeldey, Stockmair & Partner**
**Maximilianstrasse 58**
**D-8000 München 22(DE)**

(54) **Air gauge diffuser.**

(57) Disclosed are the probes (P) of an air gauge (10) with diffusers (D) which when brought into close relationship with a wafer (W) serve to reduce the velocity of the air (A) escaping from the periphery of the diffusers (D) to the point where, instead of a creating a vortex (V), any loose or floating particulate matter is blown off the wafer (W). Each diffuser (D) comprises a flat circular plate (22) affixed to, or forming a part of, the probe (P) substantially coplanar with the probe's exit orifice (20) thereby effectively increasing the diameter of the probe (P) at the interface with the wafer (W).

Fig. 4.

EP 0 258 794 A2

# AIR GAUGE DIFFUSER

## BACKGROUND OF THE INVENTION

This invention is specifically directed to an improvement in air gauges which are part of an optical focusing system used in the fabrication of integrated circuits on semiconductor wafers, but in the broader sense, is directed to the control of air flow between an air nozzle and any flat surface. Thus, the invention may be embodied in a wafer scrubber.

As part of the optical focusing system used in fabricating integrated circuits on a semiconductor wafer, an air gauge is used to place the wafer at the focal plane of the optical system. This air gauge comprises a plate with a plurality of probes which direct air onto the surface of the wafer while the wafer is being held in a chuck in close parallel relationship with the air gauge.

In practice, the wafer is placed in a chuck, typically a vacuum chuck, and moved to a focusing position where the air is directed through the probes for a few seconds to properly align the wafer. Thereafter, the air gauge is removed and exposure of the wafer takes place. Conventionally, this means that UV light is directed onto a mask on the wafer to provide the wafer with the desired pattern.

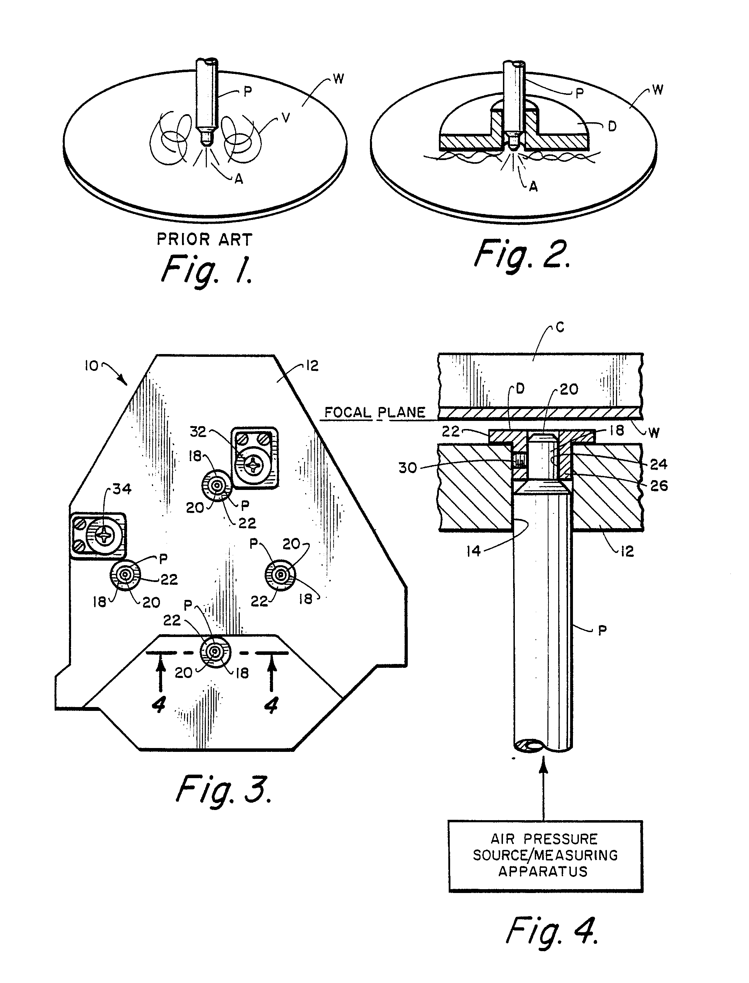

Unfortunately, it was found that the air, though itself clean, while being directed onto the wafer, created a vortex which aspirated any floating or loose particles onto the wafer surface thereby contaminating the wafer. Reference is made to Figure 1 of the drawings entitled "Prior Art" which illustrates graphically a vortex V created by the exiting air from a conventional probe P as the air A is being directed onto the surface of a wafer W. It can be seen that any particles, lying loose on the wafer, or floating around, are caught up in the vortex and deposited on the wafer surface.

Thus, it can be seen that it is desirable to eliminate the contamination of a semiconductor wafer caused by the existing probes of an air gauge.

## SUMMARY OF THE INVENTION

The present invention overcomes the above discussed defficiency of the prior art by providing the probes of an air gauge with diffusers which when brought into close relationship with a wafer serve to reduce velocity of the air escaping from the periphery of the diffusers to the point where, instead of creating vortices, any loose or floating particulate matter is blown off the wafer. Each diffuser comprises a flat circular plate affixed to, or forming part of, the probe substantially coplanar with the probe's exit orifice thereby effectively increasing the diameter of the probe at the interface with the wafer.

## BRIEF DESCRIPTION OF THE DRAWINGS

Figure 1, as previously described, is a graphic illustration of a probe and the vortex created by the exiting air being directed towards the wafer

Figure 2 is a graphic illustration of a probe with a diffuser and the manner in which the air exits along the surface and periphery of the diffuser.

Figure 3 is a view of an air gauge plate which faces the wafer in operation, with a plurality of probes and detectors, being shown, and

Figure 4 is a partial cross-sectional view of one probe and the air gauge plate, taken along line 4-4 of Figure 3 illustrating the diffuser positioned adjacent the surface of a wafer.

## DETAILED DESCRIPTION

Again, the graphic illustration of the Prior Art (Figure 1) illustrates the creation of the vortex V and its capability of aspirating particulate material onto the wafer W was discussed in the Background of the Invention and need not be discussed further so that attention can now be directed to Figures 2-4 which illustrates the preferred embodiment of the invention.

Figure 2, like Figure 1, is a graphic illustration of a probe P as part of an air gauge with a diffuser D attached thereto and, as illustrated, air A is directed from the probe toward the surface of the wafer W and then moves outwardly in waves or undulations toward the edge of the diffuser D. The diffuser functionally increases the area of the nozzle. In effect, the diffuser reduces the velocity of the air escaping around the periphery of the diffuser so that any of the particles floating in the nearby environment or that are loose enough on the wafer are blown outwardly away from the wafer. Thus, instead of aspirating particles onto the wafer as in the Prior Art, this invention produces the opposite effect.

Now in more detail, attention is directed to the specific embodiment as illustrated in Figures 3 and 4. In these figures, the air gauge 10 can be seen to comprise a plate 12 with a plurality of probes P (four shown) spaced from each other to direct air at different areas of the wafer W. Each probe P is located in a suitable bore 14 in the plate 12 and held in place relative to plate 12 in any suitable manner. Each probe P is tubular and reduced at one end to form a nozzle tip 18 with an exit orifice 20. Each tip is surrounded by a radially extending plate 22 which forms the diffuser D. The plate 22 is circular and relatively thin (0.05 in) and positioned within 0.002 in of the exit orifice. If a thicker plate such as 22 is desired, the plate 12 may be counterbored to accommodate the thicker plate. The diffuser is also provided with a central opening 24 and an integral collar 26 which is bored and threaded to receive a set screw 30 to attach the diffuser onto the tip of the probe P. Other means may be provided to attach the diffuser D to the probe P or the diffuser D may be made integral with the probe P, if desired. While not directly concerned with this invention, this air gauge 10 may also be provided with two LED detectors 32 and 34 which are used to determine the position of the edge of the wafer for the purpose of proper mask-to-wafer alignment.

As more clearly shown in Figure 4, the wafer W (shown only fragmentary in this view) is placed in a chuck C shown only partially, normally vacuum operated, which holds the wafer and the latter is brought into very close proximity (0.003 to 0.009 in) to the air gauge 10. Air A at a known pressure is directed through each of the probes P as the wafer is held very close to the air gauge. Any difference in back pressure from any of the probes will indicate that the wafer is out of alignment. The chuck C is articulately mounted and servo operated to adjust the position of the wafer within the focal plane until the back pressure from the probes indicates proper alignment. This places the wafer at, or within a few microns of, the focal plane of the system and is held by the chuck C until the wafer is exposed to UV light to produce the desired pattern on the wafer.

From the foregoing it can be seen that, the use of the diffusers reduces the possibility of contaminates being aspirated onto the wafer and it should be apparent to those skilled in the art that this same type of apparatus may be used to clean a wafer as part of a wafer scrubber.

## Claims

1. In an air gauge having at least one probe with an exit orifice to direct air towards a flat surface brought in close proximity thereto, the improvement comprising,
means for reducing the velocity of the air emitted by said probe so that any loose or floating particulate matter will not be deposited on said flat surface.

2. The air gauge as claimed in claim 1 wherein said flat surface is a semiconductor wafer.

3. The air gauge as claimed in claim 2 wherein said means for reducing the velocity comprises a relatively thin plate means substantially coplanar with said exit orifice.

4. The air gauge as claimed in claim 3 wherein said plate means is circular and said exit orifice is centrally located thereof.

5. An air gauge for aligning a surface according to preselected standard including a plurality of probes positioned on a plate and adapted to be connected to a source of air under pressure to direct air onto said surface when brought in close proximity thereto, the improvement comprising,
means for diffusing air emitted by said probes to prevent vortices from forming so that particulate matter will not be carried by said vortices.

6. The air gauge as claimed in claim 5 wherein said means diffusing air comprises means for lowering the velocity of the air from said probes.

7. The air gauge as claimed in claim 5 wherein the means for diffusing the air comprises means effectively widening the area of said probes.

8. A device for directing air toward a flat surface brought in close proximity thereto and having at least one probe means with an air exit orifice, the improvement comprising,
means for reducing the velocity of the air emitted by said probe means as the air travels along said flat surface so that any loose or floating particulate matter will be blown off said flat surface and not picked up and deposited on said flat surface.

9. The device as claimed in claim 8 wherein said means for reducing the velocity of air comprises means substantially flat and substantially coplanar with said exit orifice and spaced from said flat surface.

PRIOR ART
*Fig. 1.*

*Fig. 2.*

*Fig. 3.*

FOCAL PLANE

AIR PRESSURE
SOURCE/MEASURING
APPARATUS

*Fig. 4.*